# FASCICULE DE BREVET EUROPEEN

(11) **EP 0 763 849 B1**
(45) Date de publication et mention de la délivrance du brevet: **21.11.2001**
(21) Numéro de dépôt: 96401932.7
(22) Date de dépôt: 10.09.1996
(51) Int. Cl.: H01L 21/20, H01L 21/762

(54) **Procédé de fabrication de films minces à matériau semi-conducteur**
Verfahren zur Herstellung dünner Halbleiterschichten
Process for preparing thin semiconductor films

(30) Priorité: 13.09.1995 FR 9510718
(43) Date de publication de la demande: 19.03.1997
(73) Titulaire: COMMISSARIAT A L'ENERGIE ATOMIQUE, 75015 Paris (FR)
(72) Inventeur: Bruel, Michel, 38113 Veurey (FR)
(74) Mandataire: Dubois-Chabert, Guy

(56) Documents cités:
- EP-A- 0 417 851
- EP-A- 0 533 551

## Description

### Domaine technique

La présente invention concerne un procédé de fabrication de films minces à matériau semi-conducteur, et en particulier de films monocristallins.

De tels films trouvent de nombreuses applications dans les domaines de la microélectronique. Ils sont utilisés par exemple pour la réalisation de substrats, tels que des substrats silicium sur isolant, pour la réalisation de membranes, pour la réalisation de masques, tels ceux utilisés par exemple, dans des techniques de lithographie aux rayons X, ainsi que pour la réalisation de circuits intégrés à plusieurs couches actives.

### Etat de la technique antérieure

On sait que pour réaliser des films minces monocristallins de semi-conducteur, il existe plusieurs méthodes et procédés dont la mise en oeuvre est souvent complexe et coûteuse. En effet, s'il est relativement aisé de réaliser des films de matériau polycristallin ou amorphe, il est beaucoup plus difficile de réaliser des films monocristallins.

On peut citer comme méthodes de réalisation de films monocristallins certaines des méthodes utilisées pour la fabrication des substrats dits "Silicium sur Isolant", où le but recherché est de fabriquer un film de silicium monocristallin reposant sur un substrat isolé électriquement du film. Des méthodes d'hétéroépitaxie permettent de faire croître un cristal, par exemple en silicium, en film mince sur un substrat monocristallin d'une autre nature, dont le paramètre de maille est voisin de celui du silicium. Parmi ceux-ci, on peut citer les substrats de saphir (Al₂O₃) ou de fluorure de calcium (CaF₂). On peut se reporter à ce sujet au document (1) référencé à la fin de la présente description.

Le procédé dit "SIMOX" (Separation by IMplantation of OXygen) utilise l'implantation ionique à forte dose d'oxygène dans un substrat de silicium pour créer dans le volume du silicium une couche d'oxyde de silicium séparant un film mince de silicium monocristallin de la masse du substrat. Ce procédé est décrit plus en détail par le document (2) référencé à la fin de la présente description, auquel on peut se reporter.

D'autres procédés utilisent le principe de l'amincissement d'une plaquette par abrasion mécanochimique ou chimique ; les procédés de cette catégorie les plus performants utilisent en outre le principe de la barrière d'arrêt à la gravure (etch-stop en termes anglo-saxons) qui permet d'arrêter l'amincissement de la plaquette dès que l'épaisseur requise est atteinte et donc de garantir une homogénéité d'épaisseur. Cette technique consiste par exemple à doper de type p le substrat de type n sur l'épaisseur du film que l'on désire obtenir et à attaquer chimiquement le substrat avec un bain chimique actif pour le silicium de type n et inactif pour le silicium de type p. On peut se reporter à ce sujet aux documents (3) et (4) dont les références sont données à la fin de la présente description.

Les diverses méthodes de réalisation des films minces monocristallins présentent des inconvénients liés aux techniques de fabrication.

Les méthodes d'hétéroépitaxie sont limitées par la nature du substrat ; le paramètre de maille du substrat n'étant pas strictement exact à celui du semi-conducteur, le film mince comporte beaucoup de défauts cristallins. En outre, ces substrats sont chers et fragiles et n'existent qu'en dimension limitée.

La méthode SIMOX requiert une implantation ionique à très forte dose ce qui nécessite une machine d'implantation très lourde et complexe ; le débit de ces machines est faible et il est difficilement envisageable de l'augmenter dans des proportions notables.

Les méthodes d'amincissement ne sont compétitives du point de vue de l'homogénéité et de la qualité que si elles utilisent le principe de la barrière d'arrêt à la gravure. Malheureusement, la création de cette barrière d'arrêt rend le procédé complexe et peut limiter dans certains cas l'utilisation du film. En effet, si l'arrêt de la gravure est réalisé par dopage de type p dans un substrat de type n, la réalisation éventuelle de dispositifs électroniques dans le film doit s'accommoder de la nature de type p du film.

On connaît aussi un procédé de fabrication de films minces de matériau semi-conducteurs dans lequel on forme la couche mince en la détachant d'un substrat selon un plan défini par une implantation d'une couche de microbulles gazeuses. Ce procédé comporte trois étapes essentielles.

Une première étape consiste à bombarder une plaquette de semi-conducteur avec des ions appropriés pour y former une couche de microbulles gazeuses qui délimite dans le volume de la plaquette la couche mince.

La deuxième étape consiste à solidariser la face du substrat à travers laquelle a été effectué le bombardement, avec un raidisseur épais. Ce raidisseur, en un matériau rigide, a pour rôle de maintenir la cohésion et la forme de la couche mince pendant la troisième étape du procédé et après sa formation.

Une troisième étape consiste en un traitement thermique qui permet, par un effet de réarrangement cristallin dans la plaquette, et par un effet de pression dans les microbulles, une séparation entre le film mince et le reste du substrat. Le film mince reste cependant solidaire du raidisseur.

Au sujet de ce procédé, il est possible de se reporter aux documents (5) et (6) dont la référence est donnée à la fin de la présente description. Ce procédé, très avantageux, permet de s'affranchir des contraintes des autres procédés déjà mentionnés, telles que la nécessité d'utiliser un substrat initial de nature différente de celle du semi-conducteur choisi, la nécessité de très fortes doses d'implantation, la nécessité d'une barrière d'arrêt de gravure, etc.

Une limitation importante de ce procédé tient cependant au fait que le film mince ne peut être obtenu que par l'utilisation d'un raidisseur qui lui confère une rigidité suffisante.

Ainsi, un but de la présente invention est de proposer un procédé de fabrication d'un film mince qui présente des caractéristiques de rigidité suffisantes pour s'affranchir de l'utilisation d'un raidisseur.

Un autre but est également de proposer un procédé qui permette d'obtenir des films avec une épaisseur homogène et contrôlée.

Un but est aussi de proposer un procédé simple qu'il soit possible de mettre en oeuvre avec des énergies relativement basses.

### Exposé de l'invention

Pour atteindre ces buts, l'objet de la présente invention est un procédé de fabrication d'un film mince à matériau semi-conducteur, conforme à la revendication 1.

Au sens de la présente invention, on entend par "microbulle gazeuse" toute cavité ou microcavité générée par l'implantation d'ions de gaz d'hydrogène ou de gaz rares dans le matériau. Les cavités peuvent se présenter sous une forme très aplatie, c'est-à-dire de faible hauteur, par exemple quelques distances inter atomiques aussi bien que sous forme sensiblement sphérique et toute autre forme différente de ces deux formes précédentes. Ces cavités peuvent contenir une phase gazeuse libre et/ou des atomes de gaz issus des ions implantés fixés sur des atomes du matériau formant les parois des cavités. Ces cavités sont généralement appelées en terminologie ango-saxonne "platelet", "microblister" ou même "bubbles".

Par ailleurs, on entend par film mince rigide un film dont les propriétés mécaniques sont suffisantes pour éviter que l'application de la deuxième étape se traduise par l'apparition de gonflements, de bulles et d'éclatements de bulles, et donc pour que l'application de la deuxième étape se traduise par un décollement sur toute la surface. Ainsi, on entend par libération du film mince, le décollement complet du film. Ce film obtenu selon le procédé de l'invention est autoporté, c'est-à-dire indépendant mécaniquement et peut être utilisé directement.

La plaquette de matériau semi-conducteur peut être monocristalline ou polycristalline.

On considère par ailleurs que la couche de microbulles gazeuses est une couche de clivage lorsque l'implantation est effectuée à une dose telle que le clivage provoqué lors du traitement thermique, conduise à la séparation totale sur toute la surface du film mince. La profondeur minimum qui dépend du type de matériau utilisé pour réaliser le film mince, correspond à aussi l'épaisseur minimale qu'aura ce film.

Selon un mode de mise en oeuvre particulièrement avantageux de l'invention, il est possible de former, sur la face libre de la plaquette, avant l'étape d'implantation, au moins une couche, dite de rigidité, en un matériau ayant une rigidité supérieure à la rigidité du matériau de la plaquette, la couche présentant une épaisseur telle, et l'implantation étant effectuée à une énergie telle que la couche de rigidité puisse être traversée par les ions. La couche superficielle et la couche de rigidité forment alors le film mince.

Le film mince est alors un film multicouches qui comporte la couche superficielle et la ou les couche(s) du film de rigidité. La profondeur de pénétration minimum de l'implantation est toujours telle que l'épaisseur du film mince, c'est-à-dire de l'ensemble de ces couches aient les caractéristiques de rigidité recherchées.

Pour réaliser la couche de rigidité, on peut choisir préférentiellement des matériaux constitués d'atomes légers, c'est-à-dire de numéro atomique faible, par exemple inférieur ou égal à 14, pour lesquels le pouvoir de freinage des ions implantés est faible.

Il apparaît de façon surprenante qu'il est possible de mettre en oeuvre le procédé de l'invention avec des énergies relativement faibles. Un choix judicieux des matériaux permet d'envisager le procédé avec des énergies d'implantation inférieures à 200 keV.

D'autres caractéristiques et avantages de la présente invention ressortiront de la description qui va suivre, en référence aux dessins annexés, donnée à titre purement illustratif et non limitatif.

### Brève description des figures

La figure 1 montre de façon schématique une implantation d'ions dans une plaquette de matériau semi-conducteur conformément à une première étape du procédé de l'invention.

La figure 2 montre de façon schématique la formation d'un film mince par séparation d'une couche supérieure de la plaquette conformément à une deuxième étape de l'invention.

La figure 3 montre l'étape d'implantation d'ions dans une plaquette selon une mise en oeuvre perfectionnée de la présente invention.

La figure 4 montre la séparation d'un film mince multicouche de la plaquette selon la mise en oeuvre perfectionnée de l'invention.

### Description de modes de mise en oeuvre de l'invention

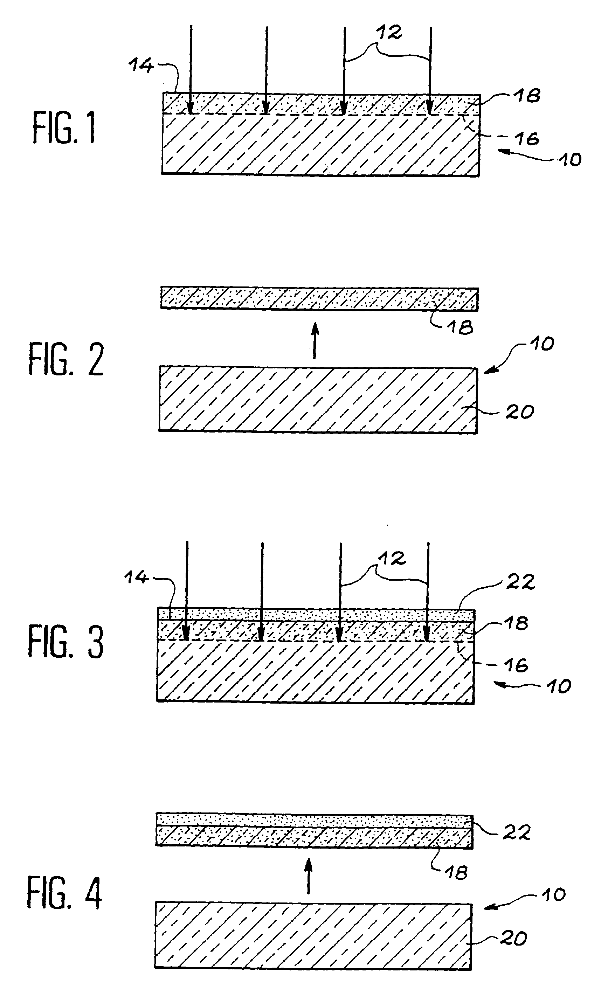

Comme le montre la figure 1, qui correspond à une première mise en oeuvre de l'invention, le procédé comporte tout d'abord une implantation d'ions dans une plaquette ou un lingot 10 de matériau semi-conducteur monocristallin ou polycristallin.

L'implantation est repérée avec des flèches qui portent la référence 12. Elle est effectuée à travers une face supérieure 14 de la plaquette 10 qui est sensiblement parallèle à un plan cristallographique principal du substrat, tel qu'un plan (1, 0, 0) par exemple. Les ions implantés sont des ions de gaz rare ou de gaz hydrogène.

L'implantation permet de former dans le volume de la plaquette, à une profondeur voisine de la profondeur moyenne de pénétration des ions, une couche de microbulles gazeuses 16. Cette couche de microbulles délimite dans la plaquette 10 une couche superficielle 18 destinée à former le film mince.

A ce sujet, la description du procédé objet du document (5) est considérée comme incluse dans la présente description à titre d'information.

On peut noter en particulier que pendant l'implantation des ions, la plaquette est préférentiellement maintenue à une température inférieure à la température à laquelle les atomes du gaz implanté peuvent s'échapper du semi-conducteur par diffusion.

Conformément à l'invention, l'implantation est effectuée à une énergie telle que la profondeur de pénétration soit supérieure ou égale à une profondeur minimum pour que le film soit rigide. Pour atteindre au moins cette profondeur minimum, l'énergie d'implantation doit donc être supérieure à une énergie seuil qui correspond à une pénétration des ions à la profondeur minimum.

La profondeur et l'énergie de l'implantation sont liées. Pour un type d'ion implanté donné, elles sont déterminées pour l'essentiel par la nature du matériau semi-conducteur utilisé.

A titre d'exemple, le tableau I, ci-après, donne une correspondance entre l'épaisseur d'un film que l'on souhaite réaliser et l'énergie d'implantation requise, dans le cas particulier de l'implantation d'ions hydrogène dans du silicium.

**Tableau I**

| | | | | |
|---|---|---|---|---|
| Epaisseur | 5 µm | 10 µm | 30 µm | 100 µm |
| Energie | 500 keV | 750 keV | 1500 keV | 3200 keV |

Le tableau II, ci-après, donne, à titre d'exemple, successivement la profondeur minimum d'implantation requise pour que le film soit rigide, la dose d'implantation minimum dans le cas où les ions sont des ions d'hydrogène, et l'énergie minimum d'implantation pour deux matériaux semi-conducteurs (Si et SiC) particulièrement bien adaptés à la mise en oeuvre de l'invention.

**Tableau II**

| | Silicium | Sic |
|---|---|---|
| Profondeur Minimum | 5 µm | 1,15 µm |
| Dose Hydrogène minimum | 510¹⁶cm⁻² | 210¹⁷cm⁻² |
| Energie minimum Hydrogène | 500 keV | 180 keV |

La figure 2 montre l'opération de clivage. Le substrat 10 subit un traitement thermique à une température supérieure à la température à laquelle est réalisé le bombardement ionique, et suffisante pour créer, par un effet de réarrangement cristallin dans la plaquette 10, et de pression dans les microbulles 16 (fig. 1), une séparation de la couche superficielle 18, de la partie massive 20 du substrat.

La couche superficielle 18 constitue alors le film mince libre.

La température du traitement thermique est de l'ordre de 500°C dans le cas où le matériau semi-conducteur utilisée est du silicium.

Une autre mise en oeuvre de l'invention, qui en constitue un perfectionnement, est représentée aux figures 3 et 4. Les parties des figures 3 et 4 identiques ou similaires à celles des figures 1 et 2 portent les mêmes références et on pourra se reporter à leur sujet, à la partie de la description qui précède.

Comme le montre la figure 3, on recouvre la face 14 du substrat 10 avec une couche de rigidité 22. Cette couche est réalisée en un matériau qui présente préférentiellement une rigidité supérieure à la rigidité du matériau semi-conducteur du substrat. Elle est en outre réalisée avant l'implantation d'ions 12.

Il est possible de former sur le substrat 10, une seule, mais aussi une pluralité de telles couches de rigidité. Celle(s)-ci est(sont) par exemple formée(s) par des techniques de dépôt chimique en phase vapeur activé par plasma (PECVD) ou à basse pression (LPCVD), ou par pulvérisation ou évaporation sous vide, ou tout simplement collée(s) sur la face 14 par des traitements de surface appropriés permettant après mise en contact l'établissement de liaisons interatomiques.

Dans l'exemple de la figure 3, une seule couche de rigidité est formée.

Il s'agit de préférence d'une couche en un matériau constitué d'atomes légers dont le pouvoir de freinage des ions implantés est faible. Le diamant (Z=6) et le carbure de silicium (Z(C))=6, Z(Si)=14) sont des matériaux que l'on sait déposer en couches, qui sont aisément traversables par les ions tels que les ions hydrogènes, et qui présentent d'excellentes propriétés mécaniques. Ces matériaux conviennent donc particulièrement pour la mise en oeuvre de l'invention. Ils sont déposés selon des méthodes connues par exemple de dépôt PECVD (Plasma Enhanced Chemical Vapor Deposition) ou LPCVD (Low Pressure Chemical Vapor Deposition).

Lorsque le substrat 10 est équipé de la couche de rigidité, il est soumis à un bombardement d'ions 12, par exemple d'ions hydrogène, afin d'y former une couche de microbulles gazeuses 16. Cette couche de microbulles permet de délimiter dans le substrat 10 une couche superficielle 18. L'énergie de l'implantation est choisie de telle sorte que les ions traversent la couche de rigidité 14 et pénètrent dans le matériau semi-conducteur. La profondeur de l'implantation qui doit donc être supérieure à l'épaisseur de la (ou des) couche(s) de rigidité, est toujours choisie de sorte que le film mince, c'est-à-dire de l'ensemble formé de la couche supérieure 18 et de la couche de rigidité 22, ait une rigidité suffisante.

Lorsque la couche de rigidité confère par elle-même au film mince une rigidité satisfaisante, l'épaisseur de la couche supérieure 18 formée dans le substrat 10 peut être choisie librement.

Le tableau III ci-après donne à titre indicatif l'épaisseur de la couche de rigidité qu'il convient de former sur la face 14 pour obtenir un film mince rigide. Le tableau III concerne des couches de rigidité en diamant et en carbure de silicium (SiC). Le tableau indique également les énergies d'implantation nécessaires pour des ions d'hydrogène afin que ceux-ci traversent les couches de rigidité.

**Tableau III**

| **MATERIAU RIGIDE** | **DIAMANT** | **SiC** |
|---|---|---|
| Epaisseur | 1 µm | 1,25 µm |
| Energie H+ | ≥200 keV | ≥200 keV |

Après l'implantation, le substrat subit un traitement thermique qui, comme le montre la figure 4 permet de libérer du substrat 10 le film mince qui comprend la couche superficielle 18 et la couche de rigidité 22.

### Documents cités dans la présente description

***(1)*** 1986, IEEE SOS/SOI Technology Workshop, Sept. 30-Oct. 2, 1986, South seas plantation resort and yacht Harbour Captiva Island, Floride.
***(2)*** SIMOX SOI for Integrated Circuit Fabrication par Hon Wai Lam, IEEE Circuits and Devices Magazine, Juillet 1987.
***(3)*** Silicon on Insulator Wafer Bonding Wafer Thinning Technological Evaluations par Haisma, Spierings, Biermann et Pals, Japanese Journal of Applied Physics, vol. 28, n°8, Août 1989.
***(4)*** Bonding of silicon wafers for silicon on insulator, par Maszra, Goetz, Caviglia et McKitterick, Journal of Applied Physic 64 (10), 15 Nov. 1988.
***(5)*** FR-A-2 681 472.
***(6)*** EP-A-533 551.

## Revendications

1. Procédé de fabrication d'un film mince à matériau semi-conducteur, comportant les étapes suivantes :
- la réalisation dans une plaquette (10) de matériau semi-conducteur d'une couche de clivage qui délimite une couche superficielle (18), la couche de clivage comprenant des microbulles gazeuses (16) formées par implantation ionique à travers une face sensiblement parallèle à un plan cristallographique du semi-conducteur,
- le traitement thermique de la plaquette à une température apte à provoquer un effet de réarrangement cristallin et un effet de pression dans les microbulles gazeuses et
- la séparation de la couche superficielle (18) d'avec le reste de la plaquette selon la couche de microbulles, la séparation étant conduite par le traitement thermique,
**caractérisé en ce que** l'on effectue l'implantation à une énergie telle que la profondeur de pénétration des ions soit supérieure à une profondeur minimum déterminée pour obtenir un film mince, comportant ladite couche superficielle, qui soit suffisamment rigide pour que le traitement thermique puisse le libérer sans provoquer de gonflements et **en ce que** l'on effectue la séparation du film mince d'avec le reste de la plaquette, sans utiliser de raidisseur pour le film mince.

2. Procédé selon la revendication 1, **caractérisé en ce qu'**avant l'étape d'implantation d'ions, on forme sur ladite face (14) de la plaquette au moins une couche (22) dite de rigidité en un matériau ayant une rigidité supérieure à la rigidité du matériau de la plaquette (10), la couche présentant une épaisseur telle, et l'implantation étant effectuée à une énergie telle, que la couche de rigidité puisse être traversée par les ions, la couche superficielle et la couche de rigidité formant alors le film mince.

3. Procédé selon la revendication 2, **caractérisé en ce que** pour former la couche de rigidité (22), on choisit un matériau avec un numéro atomique Z tel que Z≤14.

4. Procédé selon l'une quelconque des revendications 2 et 3, **caractérisé en ce qu'**on forme la couche de rigidité (22) selon une technique de dépôt chimique en phase vapeur.

5. Procédé selon l'une quelconque des revendications 2 à 4, **caractérisé en ce qu'**on rend la couche de rigidité (22) solidaire de ladite face (14) de la plaquette (10) par collage.

6. Procédé selon l'une quelconque des revendications 2 à 5, **caractérisé en ce qu'**on forme une couche de rigidité en diamant avec une épaisseur de l'ordre de 1 µm et on effectue l'implantation d'ions avec une énergie E, telle que E≥200 keV.

7. Procédé selon l'une quelconque des revendications 2 à 6, **caractérisé en ce qu'**on forme une couche de rigidité en carbure de silicium avec une épaisseur de l'ordre de 1,25 µm et on effectue l'implantation d'ions avec une énergie E telle que E≥200 keV.

8. Procédé selon la revendication 1, **caractérisé en ce que** le matériau de la plaquette est du silicium, respectivement du carbure de silicium, et **en ce que** la profondeur minimum est respectivement de 5 µm et de 1,15 µm.

## Claims

1. Process for the manufacture of a thin semiconductor material film comprising the following steps:
- the production in a semiconductor material wafer (10) of a cleavage layer defining a surface layer (18), the cleavage layer incorporating gaseous microblisters (16) formed by ion implantation through a surface substantially parallel to a crystallographic plane of the semiconductor, heat treatment of the wafer at a temperature able to bring about a crystalline rearrangement effect and a pressure effect in the gaseous microblisters and
- the separation of the surface layer (18) from the rest of the wafer along the layer of microblisters, separation taking place by heat treatment, **characterized in that** implantation takes place at an energy such that the penetration depth of the ions exceeds a minimum, given depth for obtaining a thin film, containing said surface layer, which is sufficiently rigid to enable the heat treatment to release it without bringing about swelling and **in that** the separation of the thin film from the remainder of the wafer takes place without using a stiffener for the thin film.

2. Process according to claim 1, **characterized in that** at least one so-called stiffening layer (22) made of a material with a stiffness exceeding the stiffness of the material of the wafer (10), is formed on the said surface (14) of the wafer before the ion implantation step, the layer thickness and the implantation energy being such that ions can pass through the stiffening layer, the surface layer and the stiffening layer then forming the thin film.

3. Process according to claim 2, **characterized in that** the atomic number Z of the material used to form the stiffening layer (22) is chosen such that Z ≤ 14.

4. Process according to either of the claims 2 and 3, **characterized in that** the stiffening layer (22) is formed using an enhanced vapour phase chemical deposition technique.

5. Process according to any one of the claims 2 to 4, **characterized in that** the stiffening layer (22) is attached to said surface (14) of the wafer (10) by adhesion.

6. Process according to any one of the claims 2 to 5, **characterized in that** a diamond stiffening layer with a thickness of the order of 1 µm is formed, and ion implantation is carried out with an energy E such that E ≥ 200 keV.

7. Process according to any one of the claims 2 to 6, **characterized in that** a silicon carbide stiffening layer is formed with a thickness of the order of 1.25 µm, and ion implantation is carried out with an energy E such that E ≥ 200 kev.

8. Process according to claim 1, **characterized in that** the wafer is made of silicon or silicon carbide, respectively, and the minimum depth is 5 µm and 1.15 µm respectively.

## Patentansprüche

1. Verfahren zur Herstellung einer Halbleiter-Dünnschicht, das die folgenden Schritte umfasst:
- die Erzeugung einer eine Oberflächenschicht (18) abgrenzenden Spaltschicht in einem Plättchen (10) aus Halbleitermaterial, wobei die Spaltschicht Mikrogasblasen (16) umfasst, gebildet mittels lonenimplantation durch eine zu einer kristallographischen Fläche des Halbleitermaterials im Wesentlichen parallele Fläche hindurch,
- die thermische Behandlung des Plättchens mit einer Temperatur, die einen kristallinen Umlagerungs- bzw. Neuanordnungseffekt und einen Druckeffekt in den Mikrogasbläschen verursacht, und
- die Trennung der Oberflächenschicht (18) vom restlichen Plättchen in Höhe der Mikroblasenschicht, wobei die Trennung durch die thermische Behandlung erfolgt,
**dadurch gekennzeichnet,**
**dass** man die Implantation mit einer derartigen Energie durchführt, dass die Eindringtiefe der lonen größer ist als eine bestimmte Mindesttiefe zur Herstellung einer die genannte Oberflächenschicht umfassenden Dünnschicht, die ausreichend steif ist, sodass sie durch die thermische Behandlung freigemacht werden kann, ohne dass Aufblähungen entstehen, und dadurch, dass man die Trennung der Dünnschicht vom restlichen Plättchen durchführt, ohne für die Dünnschicht eine Aussteifung bzw. Versteifung zu verwenden.

2. Verfahren nach Anspruch 1, **dadurch gekennzeichnet, dass** man vor dem lonenimplantationsschritt auf der genannten Fläche (14) des Plättchens wenigstens eine sogenannte Steifheitsschicht (22) aus einem Material bildet, das eine höhere Steifigkeit als die Steifigkeit des Materials des Plättchens (10) hat, wobei die Schicht eine derartige Dicke aufweist und die Implantation mit einer solchen Energie durchgeführt wird, dass die Steifheitsschicht von den lonen durchquert werden kann, wobei die Oberflächenschicht und die Steifheitsschicht dann die Dünnschicht bilden.

3. Verfahren nach Anspruch 2, **dadurch gekennzeichnet, dass** man zur Bildung der Steifheitsschicht (22) ein Material mit einer solchen Ordnungszahl Z wählt, dass Z≤14 ist.

4. Verfahren nach einem der Ansprüche 2 und 3, **dadurch gekennzeichnet, dass** man die Steifheitsschicht (22) mittels einer CVD-Technik bildet.

5. Verfahren nach einem der Ansprüche 2 bis 4, **dadurch gekennzeichnet, dass** man die Steifheitsschicht (22) durch Kleben fest mit der genannten Fläche (14) des Plättchens (10) verbindet.

6. Verfahren nach einem der Ansprüche 2 bis 5, **dadurch gekennzeichnet, dass** man eine Steifheitsschicht aus Diamant mit einer Dicke der Größenordnung 1 µm bildet und die lonenimplantation mit einer Energie E≥200 keV durchführt.

7. Verfahren nach einem der Ansprüche 2 bis 6, **dadurch gekennzeichnet, dass** man die Steifheitsschicht aus Siliciumcarbid mit einer Dicke der Größenordnung 1,25 um bildet und die lonenimplantation mit einer solchen Energie E durchführt, dass E≥200 keV ist.

8. Verfahren nach Anspruch 1, **dadurch gekennzeichnet, dass** das Material des Plättchens Silicium beziehungsweise Siliciumcarbid ist, und dadurch, dass die Mindesttiefe 5 µm beziehungsweise 1,15 µm beträgt.
